# EUROPEAN PATENT APPLICATION

(11) **EP 3 968 490 A1**
(43) Date of publication of application: **16.03.2022**
(21) Application number: 20825478.9
(22) Date of filing: 25.05.2020
(51) Int. Cl.: H02J 7/00

(54) **CHARGING CIRCUIT OF ELECTRONIC DEVICE, AND ELECTRONIC DEVICE**

(30) Priority: 20.06.2019 CN 201910537737
(71) Applicant: GUANGDONG OPPO MOBILE TELECOMMUNICATIONS CORP., LTD., Dongguan, Guangdong 523860 (CN)
(72) Inventor: LIU, Shaobin, Dongguan, Guangdong 523860 (CN); ZHANG, Jun, Dongguan, Guangdong 523860 (CN); BU, Changjun, Dongguan, Guangdong 523860 (CN); SHI, Yansong, Dongguan, Guangdong 523860 (CN); LI, Jiada, Dongguan, Guangdong 523860 (CN); LI, Yunlin, Dongguan, Guangdong 523860 (CN); FAN, Xun, Dongguan, Guangdong 523860 (CN); SHI, Jianchao, Dongguan, Guangdong 523860 (CN)
(74) Representative: Ipside
(86) International application number: PCT/CN2020/092140
(87) International publication number: WO 2020/253474

(57) **Abstract**

Provided are a charging circuit and an electronic device. The charging circuit comprises a first switch tube and an electromigration suppression circuit. The first end of the first switch tube is configured to be connected to a power supply, and the second end of the first switch tube is configured to be connected to a battery cell to be charged. The electromigration suppression circuit is electrically connected to the controlled end of the first switch tube; and when the power supply stops charging the battery cell to be charged, the electromigration suppression circuit adjusts a voltage difference between the second end and the controlled end of the first switch tube by means of adjusting a voltage on the controlled end of the first switch tube, so as to reduce an electromigration quantity between the second end and the controlled end of the first switch tube, thereby reducing the amount of electricity leakage of a source electrode and stabilizing the impedance between the source electrode and a gate electrode. The embodiment of the present disclosure can improve the working stability and safety of a charging circuit.

## Description

### CROSS REFERENCE

The present application claims priority of China Patent Application No. 201910537737.X, in the title of "CHARGING CIRCUIT OF ELECTRONIC DEVICE, AND ELECTRONIC DEVICE", filed on June 20, 2019, in the China National Intellectual Property Administration, the entire contents of which are hereby incorporated by reference.

### TECHNICAL FIELD

The present disclosure relates to the field of electronic device technologies, and in particular to a charging circuit of an electronic device, and an electronic device.

### BACKGROUND

A charging circuit in an electronic device may be connected to an adapter and a battery through a MOS tube, and the adapter may be controlled to charge the battery by controlling the on and off of the MOS tube. When controlling the MOS tube to be turned off, it is usually necessary to ground a gate of the MOS tube. However, since the MOS tube is always connected to the battery, a source of the MOS tube connected to the battery will always have a certain voltage. There will be a voltage difference between the source and the gate of the MOS tube, which will cause electro-migration between the gate and the source of the MOS tube, reducing an impedance between the gate and the source of the MOS tube. As a result, the impedance between a drain and the source is too large when the MOS tube is turned on, and the excessive impedance between the drain and the source causes the problems of serious heat generation and charging withdrawal during charging.

It should be noted that the information disclosed in the BACKGROUND section above is only intended to enhance the understanding of the background of the present disclosure, and therefore may include information that does not constitute the prior art known to those skilled in the art.

### SUMMARY OF THE DISCLOSURE

An object of the present disclosure is to improve the operating stability as well as the safety of the charging circuit.

To solve the above technical problems, the present disclosure uses the following technical solutions.

In a first aspect, the present disclosure provides a charging circuit of an electronic device, including: a first switch tube, wherein a first end of the first switch tube is connected to a power supply, and a second end of the first switch tube is connected to a to-be-charged battery; and an electro-migration suppression circuit, electrically connected to a controlled end of the first switch tube; wherein in condition of the power supply stopping charging the to-be-charged battery, the electro-migration suppression circuit is configured to adjust a voltage difference between the second end and the controlled end of the first switch tube by adjusting a voltage on the controlled end of the first switch tube, for reducing an electro-migration amount between the second end and the controlled end of the first switch tube.

In some embodiments, the electro-migration suppression circuit includes a first resistor, a first end of the first resistor is connected to the controlled end of the first switch tube, and a second end of the first resistor is grounded; in condition of the power supply stopping charging the to-be-charged battery, a current output by the controlled end of the first switch tube is current-limited by the first resistor and then grounded.

In some embodiments, the electro-migration suppression circuit includes a boosting circuit; in condition of the power supply stopping charging the to-be-charged battery, the boosting circuit is configured to output a level signal to the controlled end of the first switch tube, for reducing the voltage difference between the second end and the controlled end of the first switch tube.

In some embodiments, the charging circuit further includes a control circuit, a charging-mode switch circuit and a trigger circuit; wherein the charging-mode switch circuit and the trigger circuit are both controlled by the control circuit; the control circuit is configured to turn on or turn off the charging-mode switch circuit; the control circuit is configured to adjust a voltage output by an output terminal of the trigger circuit; the charging-mode switch circuit is connected in series between the controlled end of the first switch tube and a ground terminal; the output terminal of the trigger circuit is connected to the controlled end of the first switch tube; in condition of the charging-mode switch circuit being in an off state, and the voltage output from the output terminal of the trigger circuit to the controlled end of the first switch tube being greater than a turning-on voltage of the first switch tube, the power supply charges the to-be-charged battery; in condition of the charging-mode switch circuit being in an off state, and the voltage output from the output terminal of the trigger circuit to the controlled end of the first switch tube being less than the turning-on voltage of the first switch tube, the electro-migration suppression circuit acts on the controlled end of the first switch tube; in condition of the charging-mode switch circuit being in an on state, the controlled end of the first switch tube is grounded to turn off the first switch, for stopping the power supply from charging the to-be-charged battery.

In some embodiments, the electro-migration suppression circuit includes a first switch circuit; the first switch circuit is connected in series between the controlled end of the first switch tube and the output terminal of the trigger circuit; in condition of the power supply stopping charging the to-be-charged battery, the charging-mode switch circuit is turned off and the first switch circuit is turned off, to turn off a flow path of a current output by the controlled end of the first switch tube.

In some embodiments, the trigger circuit includes a second resistor, a third resistor, and a boost capacitor; a first end of the second resistor is connected to the controlled end of the first switch tube, and a second end of the second resistor is connected to a first end of the third resistor and a first end of the boost capacitor; a second end of the third resistor is connected to the power supply, and a second end of the boost capacitor is connected to the control circuit.

In some embodiments, in condition of the power supply stopping charging the to-be-charged battery, the control circuit outputs an alternation current signal to the boost capacitor, and a direct current voltage output from the boost capacitor is input to the controlled end of the first switch tube through the second resistor, to reduce the voltage difference between the controlled end and the second end of the first switch tube.

In some embodiments, the charging circuit further includes a second switch tube; wherein a controlled end of the second switch tube is connected to the controlled end of the first switch tube, a first end of the second switch tube is connected to the first end of the first switch tube, and a second end of the second switch tube is connected to the power supply.

In some embodiments, the first end of the second switch tube is connected to the power supply through a charging interface, and the charging circuit of the electronic device further includes a voltage detection circuit; in condition of the power supply stopping charging the to-be-charged battery, the voltage detection circuit detects a voltage at the charging interface, and the charging-mode switch circuit is turned on in response to the voltage at the first end of the second switch tube being greater than a preset voltage value, for turning off the first switch tube and the second switch tube.

In some embodiments, the control circuit is further configured to detect a time duration of the power supply stopping charging the to-be-charged battery; in response to the time duration of the power supply stopping charging the to-be-charged battery being greater than a preset duration, the control circuit controls the voltage detection circuit to detect the voltage at the charging interface.

In a second aspect, the present disclosure provides an electronic device including the charging circuit as described above and a battery; wherein the charging circuit is connected to the battery.

The charging circuit disclosed by the present disclosure includes a first switch tube and an electro-migration suppression circuit. A first end of the first switch tube is connected to a power supply, and a second end of the first switch tube is connected to a to-be-charged battery. The electro-migration suppression circuit is electrically connected to a controlled end of the first switch tube; wherein in condition of the power supply stopping charging the to-be-charged battery, the electro-migration suppression circuit is configured to adjust a voltage difference between the second end and the controlled end of the first switch tube by adjusting a voltage on the controlled end of the first switch tube, for reducing an electro-migration amount between the second end and the controlled end of the first switch tube. In this way, the impedance between the source and the gate is stabilized by reducing the leakage of the source, such that the driving voltage required for the gate of the first switching tube is not reduced by the electro-migration phenomenon. Therefore, this scheme can stabilize the impedance between the source and the drain of the first switching tube and reduce the serious heating of the first switching tube due to the increase of the impedance between the source and the drain when the power supply is charging the battery, which in turn leads to the operation of the protection circuit to trigger exit the charging mode. The embodiments of the present disclosure can improve the working stability as well as the safety of the charging circuit.

### BRIEF DESCRIPTION OF THE DRAWINGS

FIG. 1 is a structural schematic view of an electronic device according to an embodiment of the present disclosure.
FIG. 2 is a structural block view of an electronic device according to an embodiment of the present disclosure.
FIG. 3 is a structural block view of a charging process to a to-be-charged battery according to an embodiment of the present disclosure.
FIG. 4 is a block view of a charging circuit according to an embodiment of the present disclosure.
FIG. 5 is a block view of a charging circuit according to another embodiment of the present disclosure.
FIG. 6 is a circuit view of a charging circuit according to an embodiment of the present disclosure.
FIG. 7 is a circuit view of a charging circuit according to another embodiment of the present disclosure.
FIG. 8 is a circuit view of a charging circuit according to further another embodiment of the present disclosure.
FIG. 9 is a circuit view of a charging circuit according to further another embodiment of the present disclosure.

### DETAILED DESCRIPTION

Embodiments will now be described more fully with reference to the accompanying drawings. However, the embodiments can be implemented in various forms, and should not be construed as being limited to the examples set forth herein. On the contrary, these embodiments are provided such that the present disclosure will be more comprehensive and complete and will fully convey the concept of the embodiments to those skilled in the art. The drawings are only schematic illustrations of the present disclosure and are not necessarily drawn to scale. Same reference numerals in the drawings indicate the same or similar parts, and thus their repeated description will be omitted.

In addition, the described features, structures, or characteristics can be combined in one or more embodiments in any suitable manner. In the following description, many specific details are provided to give a sufficient understanding of the embodiments of the present disclosure. However, those skilled in the art will realize that the technical solutions of the present disclosure can be practiced without one or more of the specific details, or other methods, components, devices, steps, etc. can be used. In other cases, well-known structures, methods, devices, implementations, materials, or operations are not shown or described in detail to avoid obscuring aspects of the present disclosure by overwhelming them.

In the present disclosure, unless otherwise clearly defined and defined, the terms "connected", "coupled" and other terms should be understood in a broad sense, e.g., they may be fixed connections, detachable connections, or integral; they may be electrical connections or in communication with each other; they may be direct connections or indirect connections through an intermediary. For those skilled in the art, the specific meaning of the above terms in the present disclosure may be understood on a case-by-case basis.

In addition, in the description of the present disclosure, "plurality" means at least two, such as two, three, etc., unless otherwise specifically defined. "And/or" describes the association relationship of the associated objects, indicating that there can be three types of relationships. For example, A and/or B, can indicate the existence of A alone, B alone, and both A and B. The symbol "/" generally indicates that the associated objects are in an "or" relationship. The terms "first" and "second" are only used for descriptive purposes, and cannot be understood as indicating or implying relative importance or implicitly indicating the number of indicated technical features. Thus, the features defined with "first" and "second" may explicitly or implicitly include one or more of these features.

The embodiments of the present disclosure provide an electronic device and an electronic device charging method. The detailed description will be given below. The electronic device may be a smart phone, a tablet computer, etc.

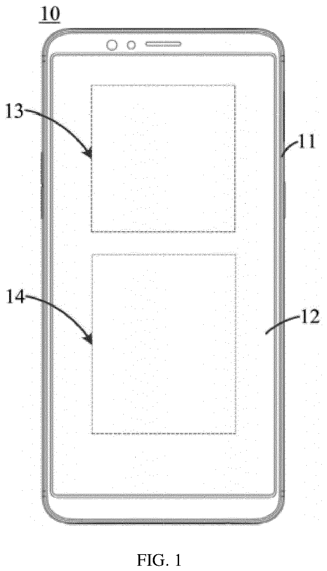

Referring to FIG. 1. FIG. 1 is a structural schematic view of an electronic device according to an embodiment of the present disclosure. The electronic device 10 may include a housing 11, a display screen 12, a circuit board 13, and a battery 14. It should be noted that the electronic device 10 includes components not limited to the above. The housing 11 may form an outer contour of the electronic device 10. In some embodiments, the housing 11 may be a metal housing, such as magnesium alloy, stainless steel and other metals. It should be noted that the material of the housing 11 in the embodiment of the present disclosure is not limited to this, and other materials may also be applied. For example, the housing 11 may be a plastic housing, a ceramic housing, a glass housing, etc.

The display screen 12 is arranged in the housing 11. The display screen 12 is electrically connected to the circuit board 13 to form a display surface of the electronic device. In some embodiments, the display surface of the electronic device 10 may be arranged with a non-display area. For example, top or/and bottom of the electronic device 10 may form a non-display area, that is, the non-display area is formed on upper or/and lower parts of the display screen 12 of the electronic device 10. The electronic device 10 may be arranged with a camera, a receiver, and other devices in the non-display area. It should be noted that the display surface of the electronic device 10 may not be arranged with a non-display area, that is, the display screen 12 may be a full screen. The display screen may be laid on the entire display surface of the electronic device 10 such that the display screen can perform full-screen display on the display surface of the electronic device 10.

It should be understood that directions or positional relationships indicated by the terms "upper", "lower", etc. are based on the directions or positional relationships shown in the drawings, and are only to facilitate and simplify the description of the present disclosure, and do not indicate or imply that the device or element referred to must have a particular orientation, constructed and operated in a particular orientation, and therefore cannot be construed as a limitation of the present disclosure. The display screen 12 may be of a regular shape, such as a rectangular structure, a rounded rectangular structure, and the display screen 12 may also be of an irregular shape.

The display screen 12 may be one or a combination of a liquid crystal display, an organic light emitting diode display, an electronic ink display, a plasma display, and a display using other display technologies. The display screen 12 may include a touch sensor array (i.e., the display screen 12 may be a touch display screen). The touch sensor may be a capacitive touch sensor formed by an array of transparent touch sensor electrodes (such as indium tin oxide (ITO) electrodes), or may be a touch sensor formed using other touch technologies, such as sonic touch, pressure-sensitive touch, resistance touch, optical touch, etc., which is not limited in the embodiments of the present disclosure.

It should be noted that, in some embodiments, a cover plate may be arranged on the display screen 12, and the cover plate may cover the display screen 12 to protect the display screen 12. The cover may be a transparent glass cover, such that the display screen 12 can display through the cover. In some embodiments, the cover plate may be a glass cover plate made of materials such as sapphire. In some embodiments, after the display screen 12 is arranged in the housing 11, a storage space is defined between the housing 11 and the display screen 12, and the storage space can contain components of the electronic device 10, such as the circuit board 13, the battery 14, etc. The circuit board 13 is arranged in the housing 11, the circuit board 13 may be a main board of the electronic device 10, and the circuit board 13 may be integrated with one, two or more of functional devices such as a motor, a microphone, a speaker, a headphone interface, a universal serial bus interface, a camera, a distance sensor, an ambient light sensor, a receiver, and a processor.

In some embodiments, the circuit board 13 may be fixed in the housing 11. Specifically, the circuit board 13 may be screwed to the housing 11 by screws, or may be snap-fitted to the housing 11 in a snap-fit manner. It should be noted that the specific way of fixing the circuit board 13 to the housing 11 in the embodiments of the present disclosure is not limited to this, and other ways, such as a way of joint fixing by a buckle and a screw, may also be used. In the description of the present disclosure, it should be noted that, unless otherwise clearly specified and limited, the terms "installation", "connection" and "coupling" should be understood in a broad sense. For example, they can be a fixed connection, a detachable connection, or an integral connection; they can be a mechanical connection, an electrical connection, or in communication with each other; they can be a direct connection, or an indirect connection through an intermediary; they can be an internal communication of two components or an interaction relationship of two components. For those skilled in the art, the specific meanings of the above-mentioned terms in the present disclosure can be understood according to specific circumstances. The battery 14 is arranged in the housing 11, and the battery 11 is electrically connected to the circuit board 13 to provide power to the electronic device 10. The housing 11 may be configured as a battery cover of the battery 14. The housing 11 covers the battery 14 to protect the battery 14 and reduce damage to the battery 14 due to collisions, drops, and the like of the electronic device 10.

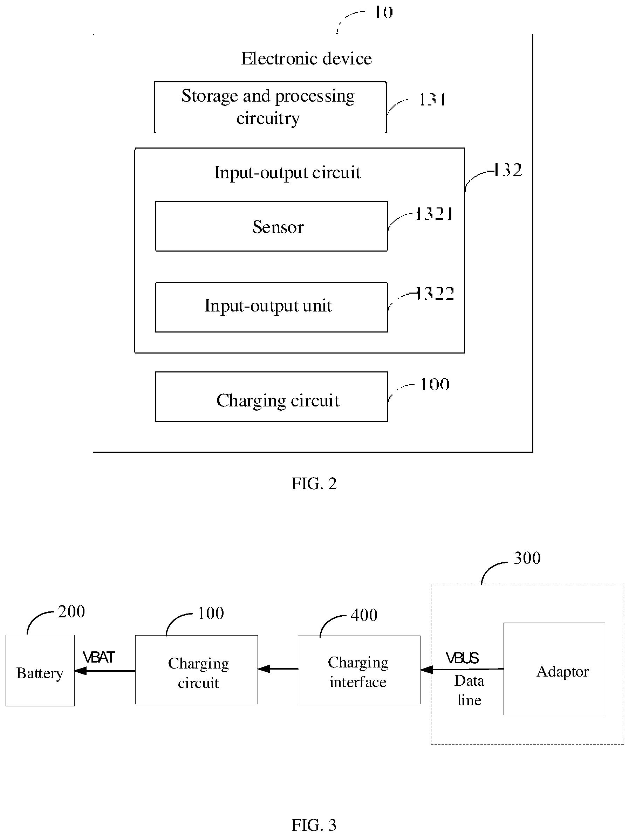

Referring to FIG. 2, FIG. 2 is a structural block view of an electronic device according to an embodiment of the present disclosure. The electronic device 10 may include a storage and processing circuit 131, and the storage and processing circuit 131 may be integrated on the circuit board 13. The storage and processing circuit 131 may include memory, such as hard disk drive memory, non-volatile memory (e.g., flash memory or other electronically programmable read-only memory used to form a solid-state drive, etc.), volatile memory (e.g., static or dynamic random access memory, etc.), etc., without limitation in the embodiments. A processing circuit of the storage and processing circuitry 131 may be configured to control the operation of the electronic device 10. The processing circuit may be implemented based on one or more microprocessors, microcontrollers, digital signal processors, baseband processors, power management units, audio codec chips, specialized integrated circuits, display driver integrated circuits, etc.

The storage and processing circuit 131 may be configured to run a software in the electronic device 10, such as Internet browsing application, voice over Internet protocol (VOIP) phone call application, email application, media playback application, and operation system functions, etc.

The electronic device 10 may include an input-output circuit 132, and the input-output circuit 132 may be arranged on the circuit board 13. The input-output circuit 132 may be configured to enable the electronic device 10 to implement data input and output, that is, allow the electronic device 10 to receive data from an external device and also allow the electronic device 10 to output data from the electronic device 10 to the external device. The input-output circuit 132 may further include a sensor 1321. The sensor 1321 may include an ambient light sensor, a proximity sensor based on light and capacitance, and a touch sensor (for example, a light-based touch sensor and/or a capacitive touch sensor, wherein the touch sensor may be a part of a touch screen or as a touch sensor structure independently), an acceleration sensor, a temperature sensor, and other sensors.

The electronic device 10 may include a power management circuit and an input-output unit 1322. The input-output unit may include button, joystick, click wheel, scroll wheel, touch pad, keypad, keyboard, camera, light emitting diode, and other status indicators.

A user can control the operation of the electronic device 10 by inputting commands through the input-output circuit 132, and can use the output data of the input-output circuit 132 to receive status information and other outputs from the electronic device 10.

Referring to FIG. 3, in the embodiment, the electronic device 10 includes a charging circuit 100. The charging circuit 100 can charge the battery 14 of the electronic device 100. The charging circuit 100 can charge the battery 14 by wired charging, or can charge the battery 14 by wireless charging. In the following embodiments, the charging circuit of the present disclosure is described in detail.

Specifically, the electronic device is arranged with a charging interface 400. The charging interface 400 may be a USB socket. The charging interface 400 is connected to an adapter through a data cable. The adapter obtains electric energy from a mains. After voltage conversion, the electric energy is transmitted through the data cable and the charging interface 400 to the charging circuit, so the electric energy can be charged into a to-be-charged battery 200 through the charging circuit.

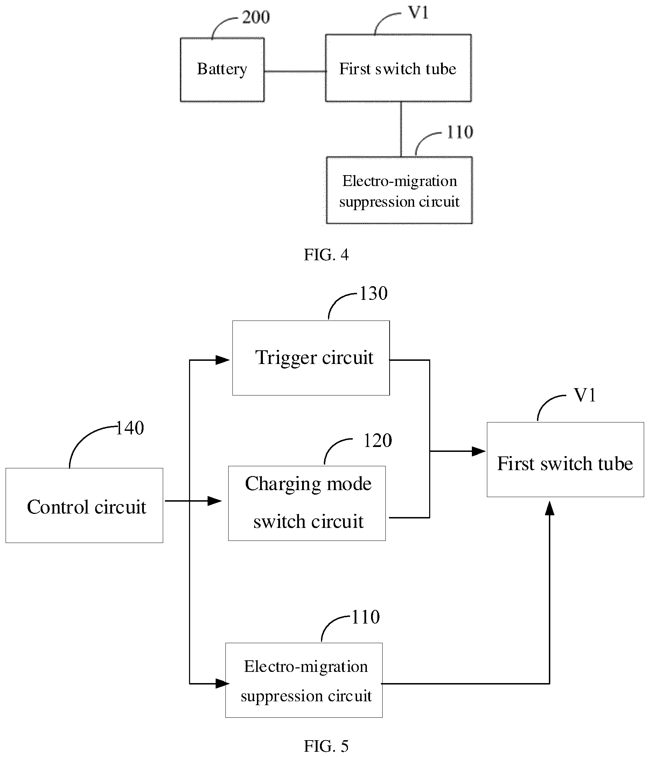

Referring to FIG. 4, the charging circuit in the embodiments of the present disclosure includes a first switch tube VI and an electro-migration suppression circuit 110. A first end of the first switch tube VI is configured to be connected to a power supply 300, and a second end of the first switch tube VI is configured to be connected to the to-be-charged battery 200. The electro-migration suppression circuit 110 is electrically connected to a controlled end of the first switch tube VI. When the power supply 300 stops charging the to-be-charged battery 200, the electro-migration suppression circuit 110 adjusts the voltage difference between the second end and the controlled end of the first switch tube VI by adjusting the voltage on the controlled end of the first switch tube VI, thereby reducing the amount of electro-migration between the second end and the controlled end of the first switch tube V1.

The power supply 300 in the embodiments is an external power supply 300 of the electronic device. Obviously, the first end of the first switch tube VI may be connected to the power supply 300 through the charging interface 400 of the electronic device. The power supply 300 may include an adapter, a data line connected between the adapter and the charging interface 400, and the mains power supply for the adapter. The power supply 300 may also be an electric energy storage device that supplies electric energy, and include a data line connected between the electric energy storage device and the charging interface 400. A path is formed for charging current to flow between the first end and the second end of the first switch tube V1, and the controlled end of the first switch tube V1 can control the on or off of the path.

There are two specific situations when the power supply 300 stops charging the to-be-charged battery 200: 1) the charging interface 400 of the electronic device is not connected to the power supply 300, so there is no power supply 300 to charge the to-be-charged battery 200; 2) the charging interface 400 of the electronic device is connected to the power supply 300, but the first switch tube VI is turned off, so the power transmitted by the adapter cannot be charged into the battery 200.

Further, when the adapter is connected to the charging interface 400 of the electronic device, there are at least two charging modes, namely, a charging mode and a charging stop mode. In the charging mode, the first switch tube VI of the charging circuit is turned on, and the adapter output current charges the battery 200 through the first switch tube VI. In the charging stop mode, the first switch tube VI is turned off, so the power supply 300 cannot charge the to-be-charged battery 200.

In the charging mode, in order to increase the charging speed, the adapter usually outputs a large current to charge the to-be-charged battery 200 with a large current through the charging circuit. It should be understood that the charging circuit may include some other circuits such as an anti-reverse circuit, a protection circuit, etc. Therefore, when the charging current is large, in order to prevent some local devices in the charging circuit from being abnormal and causing serious heating to burn up, a path impedance control may be performed in this embodiment, that is, a value of a corresponding charging current may be adjusted according to a path impedance value between the adapter and the battery. Specifically, the electronic device sends a voltage VI of an electrical energy input of the battery 200 to the adapter through the data line in real time, and the adapter obtains a path impedance value R by comparing the voltage VI with a voltage Vo output by the adapter and dividing the difference between the VI and Vo by a current I output by the adapter, R=(Vo-Vl)/I. The method of path impedance control is:

| Path impedance | R<R10 | R10<R≤R20 | R20<R<R30 | R>R30 |
|---|---|---|---|---|
| Charging current | II | 12 | 13 | Charging withdrawal |

R10, R20, and R30 each represents a preset resistance. When the path impedance is less than R10, the current II is used for fast charging; when the impedance increases to R10<R<R20, the current of the path decreases to 12 for fast charging (I2<I1); when the impedance continues to increase to R20< R<R30, the current of the path decreases to 13 for fast charging (13<12); when the impedance continues to increase to R>R30, the charging circuit is controlled by the charging circuit to stop the charging of the to-be-charged battery 200.

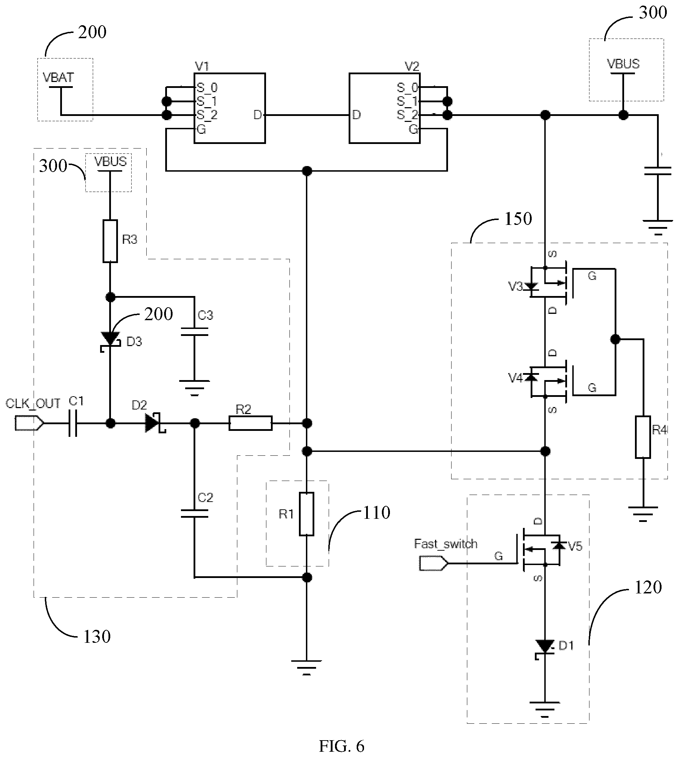

Referring to FIG. 6, VBUS is an output voltage of the power supply 300, and VBAT is a battery voltage. In the embodiment, the charging circuit of the electronic device further includes a second switch tube V2. A controlled end of the second switch tube V2 is connected to the controlled end of the first switch tube VI, a first end of the second switch tube V2 is connected to the power supply 300, and a second end of the second switch tube V2 is connected to the first end of the first switch tube VI. Since the controlled end of the second switch tube V2 is connected to the controlled end of the first switch tube V1, under normal circumstances, the first switch tube VI and the second switch tube V2 are turned on and turned off synchronously. The arrangement of the second switch tube V2 can improve the controlled reliability of the charging path between the power supply 300 and the battery, and prevent the first switch tube V1 from malfunctioning and out of control which results in an uncontrolled charging path. Moreover, when the first switch tube VI is a MOS tube, an anode of a body diode in the MOS tube is connected to the battery 200, and the voltage of a cathode is substantially the voltage of the power supply 300. Therefore, when the voltage of the battery 200 is greater than the battery voltage, a phenomenon of backflow will occur. While since the second switch tube V2 is arranged, and the second switch tube V2 and the first switch tube VI are reversely connected, the body diode of the second switch tube V2 and the body diode of the first switch tube VI are turned on in the opposite direction, which plays a role in preventing backflow.

The first switch tube VI and the second switch tube V2 may both be triodes or MOS tubes. In the following embodiments, the first switch tube V1 and the second switch tube V2 are both NMOS tubes as an example for description. A source of the second switch tube V2 is connected to the power supply 300, a drain of the second switch tube V2 is connected to the drain of the first switch tube VI, and the source of the first switch tube VI is connected to the to-be-charged battery 200.

Further referring to FIG. 4, when the power supply 300 is charging the to-be-charged battery 200, the first switch tube VI is in a turned-on state, and the electro-migration suppression circuit 110 does not act on the controlled end of the first switch tube VI. Therefore, the electro-migration suppression circuit 110 will not affect the normal charging process of the electronic device. Specifically, the charging circuit includes a control circuit 140 configured to coordinate and control the work of various functional circuits in the charging circuit. The control circuit 140 may be the main control circuit of the entire electronic device. In some embodiments, the control circuit 140 may be an MCU. The electro-migration suppression circuit 110 is controlled by the control circuit 140, such that when the power supply 300 stops charging the to-be-charged battery 200, the electro-migration suppression circuit 110 starts to act on the controlled end of the first switch tube VI to adjust the voltage of the controlled end of the first switch tube VI.

Referring to FIG. 5, in the embodiment, the power supply circuit may further include a charging-mode switch circuit 120 and a trigger circuit 130 that are both controlled by the control circuit 140. The control circuit 140 controls the charging-mode switch circuit 120 to be turned on or turned off. The control circuit 140 adjusts the voltage output by the output terminal of the trigger circuit 130. The charging-mode switch circuit 120 is connected in series between the controlled end of the first switch tube VI and a ground terminal. An output terminal of the trigger circuit 130 is connected to the controlled end of the first switch tube VI. When the charging-mode switch circuit 120 is disconnected, the output terminal of the trigger circuit 130 outputs voltage to the controlled end of the first switch tube VI to trigger the first switch tube VI to be turned on, such that the power supply 300 charges the battery 200. When the charging-mode switch circuit 120 is connected, a ground voltage transmitted by the switch circuit to the controlled end of the first switch tube VI triggers the first switch tube VI to be turned off, such that the power supply 300 stops charging the battery 200.

In the embodiments, the charging-mode switch circuit 120 cooperates with the trigger circuit 130. The charging-mode switch circuit 120 may disconnect the path between the controlled end of the first switch tube VI and the ground, such that the first switch tube VI can receive the voltage output from the output terminal of the trigger circuit 130, further triggering the first switch tube VI to be turned on to start the charging mode. Similarly, the charging-mode switch circuit 120 may turn on the path between the controlled end of the first switch tube V1 and the ground, and ground the controlled end of the first switch tube VI to cause the shutdown to start the charging stop mode.

Referring to FIG. 6, specifically, the control circuit 140 may include a switch control terminal Fast_switch, and the charging-mode switch circuit 120 may include a switch MOS tube and a first diode D1. The MOS tube may be an NMOS tube. A gate of the switch MOS tube is connected to the switch control terminal Fast_switch of the control circuit 140, a source of the switch MOS tube is connected to an anode of the first diode Dl, a cathode of the first diode D 1 is grounded, and a drain of the switch MOS tube is connected to the gate of the first switch tube V1. It should be understood that the switch MMOS tube may also be replaced by a triode.

The control circuit 140 may further include a trigger terminal CLK_OUT. The trigger terminal CLK_OUT may be controlled to send out an alternation current (AC) signal. The AC signal may be a sine wave or a square wave. The trigger circuit 130 may include a second resistor R2, a third resistor R3, a boost capacitor C1, a second capacitor C2, a third capacitor C3, a second diode D2 and a third diode D3 for anti-backflow effects. A first end of the second resistor R2 is connected to the gate of the first switch tube V1, and a second end of the second resistor R2 is interconnected with a first end of the third resistor R3 and a first end of the boost capacitor C1 through the second diode D2. A second end of the third resistor R3 is connected to the power supply 300, and a second end of the boost capacitor C1 is connected to the trigger terminal CLK_OUT of the control circuit 140. A cathode of the second diode D2 is connected to the second end of the second resistor R2, and a cathode of the third diode D3 is interconnected with an anode of the second diode D2 and the first end of the boost capacitor C1. A first end of the third resistor is grounded through the third capacitor C3 to reduce the voltage ripple of the first end of the third resistor R3. The cathode of the second diode D2 is grounded through the second capacitor C3 to reduce the voltage ripple at the cathode of the second diode D2.

Based on the above circuit structure, it is taken as an example that the first switch tube VI and the second switch tube V2 are both NMOS tubes. When the output of the switch control terminal Fast_switch is high, the switch MOS tube is turned on such that the gate of the first switch tube VI is grounded. At this time, both the first switch tube VI and the second switch tube V2 are turned off to stop the charging of the to-be-charged battery 200. When the output of the switch control terminal Fast_switch is low, the switch MOS tube is turned off such that the gate voltage of the first switch transistor VI is controlled by the output terminal of the trigger circuit 130. At this time, the trigger terminal CLK_OUT of the control circuit 140 outputs an AC signal to the boost capacitor C1, such that the boost capacitor C1 has a voltage, which is superimposed with the voltage of the power supply 300 and is input to the gate of the first switch tube VI and the gate of the second switch tube V2. Because the source voltage of the second switch tube V2 is the voltage of the power supply 300, the gate voltage of the second switch tube V2 is greater than the source voltage, and the second switch tube V2 is turned on. The voltage of the to-be-charged battery 200 is generally less than the voltage of the power supply 300, therefore, the first switch tube VI will also be turned on. At this time, the power supply 300 starts to charge the to-be-charged battery 200.

Based on the above embodiments, the electro-migration suppression circuit 110 will be described more fully in the following embodiments.

When the charging-mode switch circuit 120 is turned on, the gate of the first switch tube VI is grounded through the switch MOS tube, and the source of the first switch tube VI is connected to the to-be-charged battery 200, thus causing a voltage difference between the source and drain of the first switch tube V1. Therefore, metal ions on the source will move towards the drain under the action of the voltage difference, electro-migration occurs, causing leakage of the source, and the impedance between the source and the gate is reduced, causing the driving voltage required by the gate of the first switch tube VI is reduced, which in turn causes the impedance between the source and drain to increase when the first switch tube VI is turned on. When the degree of electro-migration is severe, the impedance between the source and the drain will be too large, which causes the first switch tube VI to generate severe heat, causing a protection circuit operation to perform for triggering the exit from the charging mode.

In the embodiment, the voltage of the gate of the first switch tube VI is adjusted, such that the voltage difference between the source and the gate of the first switch tube VI is adjusted, thereby reducing the electro-migration phenomenon between the source and the gate of the first switch tube V1.

Referring to FIG. 6, in some embodiments, the electro-migration suppression circuit 110 includes a first resistor R1, a first end of the first resistor R1 is connected to the gate of the first switch tube VI, and a second end of the first resistor R1 is grounded. When the power supply 300 stops charging the to-be-charged battery 200, the current output by the gate of the first switch tube VI is current-limited by the first resistor R1 and then grounded.

When electro-migration occurs between the source and gate of the first switch tube VI, the current generated by the electro-migration will flow through the first resistor R1, and then generate a voltage drop across the first resistor R1, such that the voltage applied between the source and gate of the first switch tube VI will be reduced, thereby suppressing the occurrence of electro-migration. The first resistor R1 with a larger resistance value may be selected, such that the current flowing between the source and the gate of the first switch tube V1 will be limited to a relatively small value, and together with the voltage drop across the first resistor R1, the voltage between the source and gate of the first switch tube VI is further reduced.

When the application environment of the electro-migration suppression circuit 110 includes the above charging-mode switch circuit 120 and the trigger circuit 130, there are two situations. The first situation is that the to-be-charged battery 200 is charged without the power supply 300. At this time, the charging-mode switch circuit 120 is turned off under the control of the control circuit 140, and since no power supply 300 is connected to the third resistor R3 of the trigger circuit 130, the trigger circuit 130 cannot provide voltage that triggers the first switch tube VI and the second switch tube V2 to be turned on. Therefore, the first switch tube VI and the second switch will still remain in the off state, such that the electro-migration suppression circuit 110 will individually act on the gate of the first switch tube VI, that is, the first resistor R1 suppresses the electro-migration current output from the gate of the first switch tube V1. The second situation is that the power supply 300 is ready to charge the to-be-charged battery 200, but the charging-mode switch circuit 120 is set to be turned off, and the trigger circuit 130 cannot output voltage that causes the first switch tube VI and the second switch tube V2 to be turned on. The trigger circuit 130 includes a reverse diode to prevent current from flowing into the trigger circuit 130 from the gate of the first switch tube VI, such that the first switch tube VI and the second switch are remained in the off state, while making the electro-migration suppression circuit 110 will act on the gate of the first switch tube VI individually, that is, the first resistor R1 suppresses the electro-migration current output from the gate of the first switch tube V1.

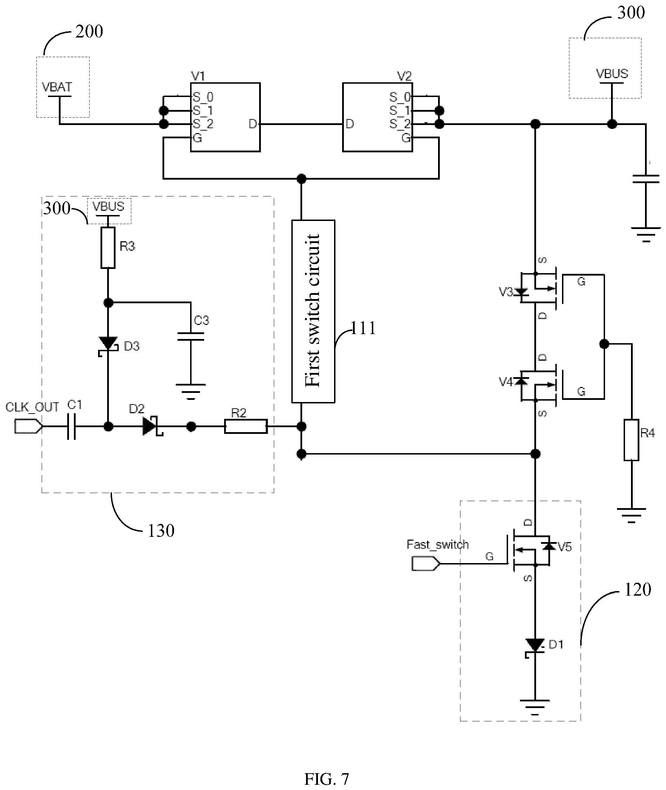

Referring to FIG. 7, in other embodiments, the electro-migration suppression circuit 110 includes a first switch circuit 111; the first switch circuit 111 is connected in series between the gate of the first switch tube VI and the output terminal of the trigger circuit 130. When the power supply 300 stops charging the to-be-charged battery 200, the charging-mode switch circuit 120 is turned off and the first switch circuit 111 is turned off to disconnect a flow path for the gate of the first switch tube VI to output the electro-migration current. Specifically, the first switch circuit 111 may be adopted with a triode or a MOS transistor.

When the application environment of the electro-migration suppression circuit 110 includes the above charging-mode switch circuit 120 and the trigger circuit 130, the charging-mode switch circuit 120 may be controlled to be turned off, and since the first switch circuit 111 is arranged between the gate of the first switch tube VI and the output terminal of the trigger circuit 130, the path between the trigger circuit 130 and the first switch tube VI is cut off. In this way, the first switch tube VI and the second switch tube V2 cannot be turned on, and the flow path for the gate of the first switch tube VI to output the electro-migration current is cut off.

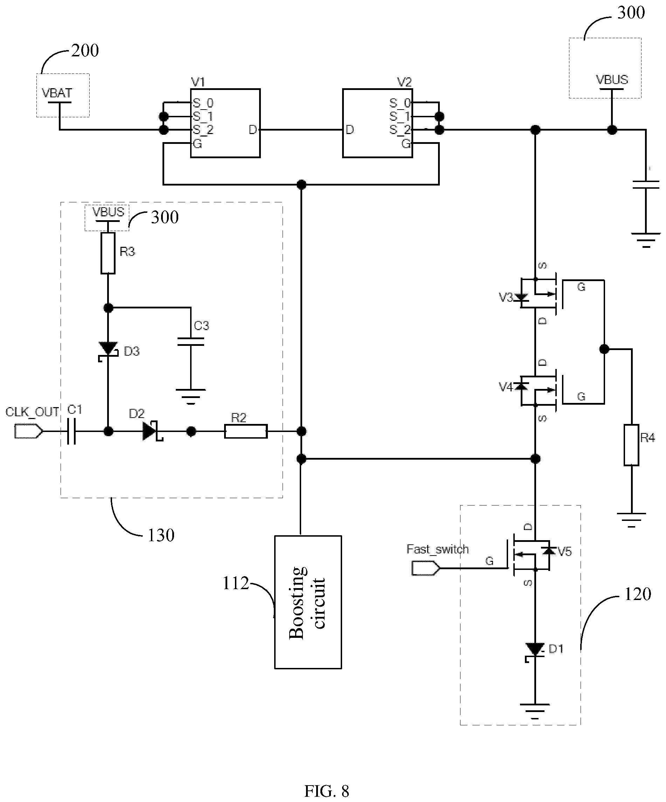

Referring to FIG. 8, in other embodiments, the electro-migration suppression circuit 110 includes a boosting circuit 112. When the power supply 300 stops charging the to-be-charged battery 200, a level signal output by the boosting circuit 112 reaches the gate of the first switch tube VI to reduce the voltage difference between the gate and the source of the first switch tube V1.

In some embodiments, the boosting circuit 112 may obtain a voltage for boosting from the control circuit 140 and connect to the gate of the first switching tube VI through a second switch circuit, such that when the power supply 300 stops charging the to-be-charged battery 200, the first switch tube VI is turned on. In this way, the voltage for boosting is applied to the gate of the first switch tube VI to reduce the voltage difference between the source and the gate of the first switch tube VI, thereby suppressing the electro-migration phenomenon.

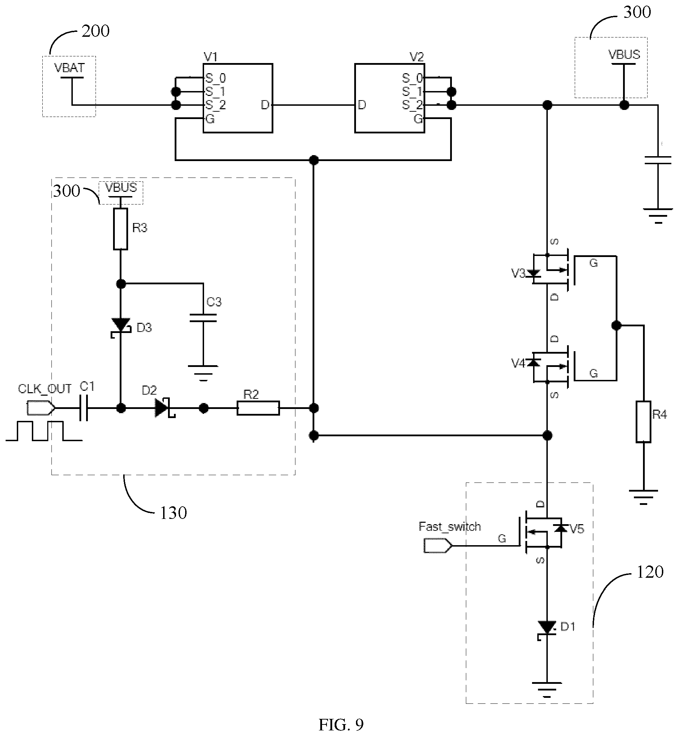

Referring to FIG. 9, in other embodiments, some components in the trigger circuit 130 are used to suppress the electro-migration phenomenon. When there is no power supply 300 to charge the to-be-charged battery 200, the control circuit 140 controls the charging-mode switch circuit 120 to be turned off, and since the no power supply 300 is connected to the third resistor R3 of the trigger circuit 130, the trigger circuit 130 cannot provide a voltage that triggers the first switch tube VI and second switch tube V2 to be turned on. Therefore, the first switch tube VI and the second switch tube V2 will still remain in the off state. At this time, the control circuit 140 outputs an AC signal to the boost capacitor C1, and the boost capacitor C1 outputs a direct current (DC) level after energy storage, which is then input to the gate of the first switch tube VI through the second resistor R2, thereby achieving the purpose of boosting the gate of the first switch tube VI and thus achieving the purpose of suppressing electro-migration.

Based on the above embodiments corresponding to FIGS. 6, 8 and 9, the present disclosure also proposes a solution to reduce or avoid corrosion of the charging interface 400. When an electro-migration phenomenon occurs at the gate of the first switch tube V1, this solution can effectively reduce or avoid corrosion of the charging interface 400.

Here, the embodiment of the electro-migration suppression circuit 110 corresponding to FIG. 6 is taken as an example to illustrate the cause of the corrosion phenomenon of the charging interface. When the power supply 300 stops charging the to-be-charged battery 200, the gate of the first switch tube VI undergoes electro-migration, the gate of the first switch tube VI and the gate of the second switch tube V2 are grounded through the first resistor R1, and the gate voltage of the first switch tube VI is a voltage division between a resistance between the gate-source of the first switch tube VI and the first resistor R1. Therefore, as the electro-migration phenomenon proceeds, the gate voltage of the first switch tube V1 will gradually increase. When the gate voltage of the first switch tube VI exceeds a turning-on voltage of the second switch tube V2, the second switch tube V2 will be turned on, such that the charging interface 400 connected to the source of the second switch tube V2 has a voltage (for example, IV). In this way, the charging interface 400 will corrode over time.

In the embodiment, in order to effectively determine the electro-migration situation of the first switch tube VI, a first end of a third switch tube V3 is connected to the power supply 300 through the charging interface 400, and the charging circuit of the electronic device further includes a voltage detection circuit. When the power supply 300 stops charging the to-be-charged battery 200, the voltage detection circuit detects the voltage on the charging interface 400.

When no voltage is detected on the charging interface 400, it means that the electro-migration phenomenon of the gate of the first switch tube VI is not serious at this time, so the electro-migration suppression circuit 110 can remain continuing to act on the gate of the first switch tube VI, thereby continuously suppressing the occurrence of electro-migration. When a voltage is detected on the charging interface 400, it means that the electro-migration phenomenon of the gate of the first switch tube VI is serious at this time, and the electro-migration suppression circuit 110 is no longer able to effectively suppress the electro-migration phenomenon. At this time, the electro-migration circuit may be controlled to stop acting on the gate of the first switch tube VI, and the charging-mode switch circuit 120 may be controlled to be turned on, such that the electro-migration suppression circuit 110 is short-circuited and stops acting on the gate of the first switch tube VI. In this way, the gate of the first switch tube VI and the gate of the second switch tube V2 are turned off by the charging-mode switch circuit 120 being grounded, such that the charging interface 400 no longer has voltage, thereby avoiding corrosion caused by the charging interface 400 being charged for a long time.

In an embodiment of a specific application, the main control board of the electronic device or the detection circuit control circuit 140 of the charging circuit detects whether the charging interface 400 is connected to the power supply 300. When the charging interface 400 is not connected to the power supply 300, the charging-mode switch circuit 120 is controlled to be turned off, and obtaining the voltage on the charging interface 400 is started after a time delay period. When the voltage on the charging interface 400 is less than or equal to a preset voltage value, the charging-mode switch circuit 120 remains being turned off, such that the electro-migration suppression circuit 110 remains acting on the gate of the first switch tube VI to continuously suppress the occurrence of electro-migration. When the voltage on the charging interface 400 is greater than the preset voltage value, the charging-mode switch circuit 120 is controlled to be turned on, such that the gate of the first switch tube VI and the gate of the second switch tube V2 are turned off by the charging-mode switch circuit 120 being grounded, and the charging interface 400 no longer has voltage, thereby avoiding corrosion caused by the charging interface 400 being charged for a long time.

Based on the above embodiments, the charging circuit may further include an anti-negative voltage circuit 150, which is connected to the source of the second switch tube V2. The anti-negative voltage circuit 150 includes the third switch tube V3 and a fourth switch tube V4; the third switch tube V3 and the fourth switch tube V4 may both be NMOS tubes. A gate of the third switch tube V3 and a gate of the fourth switch tube V4 are grounded through the fourth resistor R4, a source of the third switch tube V3 is connected to the source of the second switch tube V2, a drain of the third switch tube V3 is connected to a drain of the fourth switch tube V4, and a source of the fourth switch tube V4 is connected to a drain of a switch tube V5. When a negative voltage occurs in the power supply 300, the third switch tube V3 and the fourth switch tube V4 will be triggered to be turned on, thereby leading the negative voltage to the ground to ensure the safety of the electronic device.

Although the present disclosure has been described with reference to a few typical embodiments, it should be understood that the terms used are illustrative and exemplary rather than restrictive. Since the present disclosure can be implemented in various forms without departing from the spirit or essence of the present disclosure, it should be understood that the above embodiments are not limited to any of the foregoing details, but should be interpreted broadly within the spirit and scope defined by the appended claims. Therefore, all changes and modifications falling within the scope of the claims or their equivalents shall be covered by the appended claims.

## Claims

1. A charging circuit of an electronic device, **characterized by** comprising:
a first switch tube, wherein a first end of the first switch tube is connected to a power supply, and a second end of the first switch tube is connected to a to-be-charged battery; and
an electro-migration suppression circuit, electrically connected to a controlled end of the first switch tube; wherein in condition of the power supply stopping charging the to-be-charged battery, the electro-migration suppression circuit is configured to adjust a voltage difference between the second end and the controlled end of the first switch tube by adjusting a voltage on the controlled end of the first switch tube, for reducing an electro-migration amount between the second end and the controlled end of the first switch tube.

2. The charging circuit according to claim 1, wherein the electro-migration suppression circuit comprises a first resistor, a first end of the first resistor is connected to the controlled end of the first switch tube, and a second end of the first resistor is grounded;
in condition of the power supply stopping charging the to-be-charged battery, a current output by the controlled end of the first switch tube is current-limited by the first resistor and then grounded.

3. The charging circuit according to claim 1, wherein the electro-migration suppression circuit comprises a boosting circuit;
in condition of the power supply stopping charging the to-be-charged battery, the boosting circuit is configured to output a level signal to the controlled end of the first switch tube, for reducing the voltage difference between the second end and the controlled end of the first switch tube.

4. The charging circuit according to any one of claims 1-3, further comprising a control circuit, a charging-mode switch circuit and a trigger circuit; wherein the charging-mode switch circuit and the trigger circuit are both controlled by the control circuit; the control circuit is configured to turn on or turn off the charging-mode switch circuit; the control circuit is configured to adjust a voltage output by an output terminal of the trigger circuit;
the charging-mode switch circuit is connected in series between the controlled end of the first switch tube and a ground terminal; the output terminal of the trigger circuit is connected to the controlled end of the first switch tube;
in condition of the charging-mode switch circuit being in an off state, and the voltage output from the output terminal of the trigger circuit to the controlled end of the first switch tube being greater than a turning-on voltage of the first switch tube, the power supply charges the to-be-charged battery;
in condition of the charging-mode switch circuit being in an off state, and the voltage output from the output terminal of the trigger circuit to the controlled end of the first switch tube being less than the turning-on voltage of the first switch tube, the electro-migration suppression circuit acts on the controlled end of the first switch tube;
in condition of the charging-mode switch circuit being in an on state, the controlled end of the first switch tube is grounded to turn off the first switch, for stopping the power supply from charging the to-be-charged battery.

5. The charging circuit according to claim 4, wherein the electro-migration suppression circuit comprises a first switch circuit;
the first switch circuit is connected in series between the controlled end of the first switch tube and the output terminal of the trigger circuit;
in condition of the power supply stopping charging the to-be-charged battery, the charging-mode switch circuit is turned off and the first switch circuit is turned off, to turn off a flow path of a current output by the controlled end of the first switch tube.

6. The charging circuit according to claim 4, wherein the trigger circuit comprises a second resistor, a third resistor, and a boost capacitor;
a first end of the second resistor is connected to the controlled end of the first switch tube, and a second end of the second resistor is connected to a first end of the third resistor and a first end of the boost capacitor; a second end of the third resistor is connected to the power supply, and a second end of the boost capacitor is connected to the control circuit.

7. The charging circuit according to claim 6, wherein in condition of the power supply stopping charging the to-be-charged battery, the control circuit outputs an alternation current signal to the boost capacitor, and a direct current voltage output from the boost capacitor is input to the controlled end of the first switch tube through the second resistor, to reduce the voltage difference between the controlled end and the second end of the first switch tube.

8. The charging circuit according claim 4, further comprising a second switch tube; wherein a controlled end of the second switch tube is connected to the controlled end of the first switch tube, a first end of the second switch tube is connected to the first end of the first switch tube, and a second end of the second switch tube is connected to the power supply.

9. The charging circuit according to claim 8, wherein the first end of the second switch tube is connected to the power supply through a charging interface, and the charging circuit of the electronic device further comprises a voltage detection circuit;
in condition of the power supply stopping charging the to-be-charged battery, the voltage detection circuit detects a voltage at the charging interface, and the charging-mode switch circuit is turned on in response to the voltage at the first end of the second switch tube being greater than a preset voltage value, for turning off the first switch tube and the second switch tube.

10. The charging circuit according to claim 9, wherein the control circuit is further configured to detect a time duration of the power supply stopping charging the to-be-charged battery; in response to the time duration of the power supply stopping charging the to-be-charged battery being greater than a preset duration, the control circuit controls the voltage detection circuit to detect the voltage at the charging interface.

11. An electronic device, **characterized by** comprising a charging circuit according to any one of claims 1-10 and a battery; wherein the charging circuit is connected to the battery.
